# EUROPEAN PATENT APPLICATION

(11) **EP 4 734 682 A1**
(43) Date of publication of application: **29.04.2026**
(21) Application number: 24832224.0
(22) Date of filing: 03.05.2024
(51) Int. Cl.: H05K 7/20

(54) **HEAT DISSIPATION STRUCTURE AND ELECTRONIC DEVICE COMPRISING SAME**

(30) Priority: 30.06.2023 CN 202310800766; 05.07.2023 KR 20230087102
(71) Applicant: Samsung Electronics Co., Ltd., Suwon-si, Gyeonggi-do 16677 (KR)
(72) Inventor: YU, Sangsoo, Suwon-si Gyeonggi-do 16677 (KR); ZHAO, Guangxin, Shenzhen, Guangdong 518000 (CN)
(74) Representative: Gulde & Partner
(86) International application number: PCT/KR2024/006039
(87) International publication number: WO 2025/005440

(57) **Abstract**

According to embodiments of the present disclosure, an electronic device is provided, and may comprise: a housing including a plurality of first fins; a vapor chamber including a plurality of second fins, a first cover, a second cover, and a plurality of pillars; an electronic component; and a printed circuit board (PCB). The housing may include at least one heatsink portion forming an opening area. The vapor chamber may be disposed such that at least a part of the first surface of the first cover of the vapor chamber is exposed through the opening area. The plurality of second fins may be disposed on the exposed at least part of the first surface of the first cover. The electronic component may be disposed on one surface of the printed circuit board, and may be disposed in a space between the first surface of the second cover facing the one surface of the printed circuit board and the one surface of the printed circuit board.

## Description

### [Technical Field]

The disclosure relates to a heat dissipation structure and an electronic device including the same.

### [Background Art]

An electronic device may include various electronic components to perform communication. The electronic components in the electronic device may generate heat. For example, heat generated from an electronic component may degrade performance of the electronic component and another electronic component. In order to disperse the heat generated from the electronic component, the electronic device may include a heat dissipation structure.

The above-described information may be provided as a related art for the purpose of helping understanding of the present disclosure. No argument or decision is made as to whether any of the above description may be applied as a prior art related to the present disclosure.

### [Disclosure]

### [Technical Solution]

According to embodiments of the present disclosure, an electronic device is provided. The electronic device may comprise a housing including a plurality of first fins, a plurality of second fins, a vapor chamber including a first cover, a second cover, and a plurality of pillars, an electronic component, and a printed circuit board (PCB). The housing may include at least one heatsink portion forming an opening region. The vapor chamber may be disposed such that at least a portion of a first side of the first cover of the vapor chamber is exposed through the opening region. The plurality of second fins may be disposed on the exposed at least the portion of the first side of the first cover. The electronic component may be disposed on a side of the printed circuit board. The electronic component may be disposed in a space between a first side of the second cover facing the side of the printed circuit board and the side of the printed circuit board.

According to embodiments of the present disclosure, an electronic device is provided. The electronic device may comprise a housing including a plurality of first fins, a plurality of modules, and a printed circuit board (PCB). Each module among the plurality of modules may comprise a plurality of second fins, a vapor chamber including a first cover, a second cover, and a plurality of pillars, and an electronic component. The housing may include at least one heatsink portion forming an opening region. The vapor chamber may be disposed such that at least a portion of a first side of the first cover of the vapor chamber is exposed through the opening region. The plurality of second fins may be disposed on the exposed at least the portion of the first side of the first cover. The electronic component may be disposed on a side of the printed circuit board. The electronic component may be disposed in a space between a first side of the second cover facing the side of the printed circuit board and the side of the printed circuit board.

According to embodiments of the present disclosure, a vapor chamber is provided. The vapor chamber may comprise a first metal structure and a second metal structure. The second metal structure may be coupled to the first metal structure and may form a space for a fluid between the first metal structure and the second metal structure. The vapor chamber may comprise a plurality of pillars disposed in the space. The first metal structure may be formed based on a clad in which a first metallic material and a second metallic material are combined. The second metal structure may be formed based on a clad in which the first metallic material and the second metallic material are combined. The first metal structure may be disposed such that the first metallic material is located at a first side of the first metal structure and the second metallic material is located at a second side of the first metal structure opposite to the first side. The second metal structure may be disposed such that the first metallic material is located at a first side of the second metal structure and the second metallic material is located at a second side of the second metal structure opposite to the first side. At least a portion of the second side of the first metal structure may be coupled to at least a portion of the second side of the second metal structure. The first metallic material may comprise aluminum. The second metallic material may comprise copper.

According to embodiments of the present disclosure, a vapor chamber is provided. The vapor chamber may comprise a first metal structure and a second metal structure. The second metal structure may be coupled to the first metal structure and may form a space for a fluid between the first metal structure and the second metal structure. The vapor chamber may comprise a plurality of pillars disposed in the space. The vapor chamber may comprise a third metal structure. The third metal structure may be formed based on a first metallic material. The first metal structure and the second metal structure may be formed based on a second metallic material. A first side of the first metal structure may be coupled to the third metal structure. At least a portion of a second side opposite to the first side of the first metal structure may be coupled to at least a portion of the second metal structure. The first metallic material may comprise aluminum. The second metallic material may comprise copper.

### [Description of the Drawings]

FIG. 1 illustrates a wireless communication system.
FIG. 2 illustrates an example of an external appearance of an electronic device including a heat dissipation structure.
FIG. 3 illustrates an example of an electronic device including a heat dissipation structure.
FIG. 4A is an exploded perspective view of a vapor chamber of a heat dissipation structure.
FIG. 4B is a cross-sectional view of a vapor chamber of a heat dissipation structure.
FIG. 5A illustrates a cross-sectional view of an electronic device including a heat dissipation structure.
FIG. 5B illustrates an example of elements in which heat is dispersed.
FIGS. 6A to 6B illustrate examples of dispositions of a plurality of fins for heat dissipation.
FIG. 7A illustrates an example of a vapor chamber comprising a plurality of metallic materials.
FIG. 7B illustrates another example of a vapor chamber comprising a plurality of metallic materials.
FIG. 8 illustrates an example of an electronic device including a heat dissipation structure.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

A term referring to a component of an electronic device (e.g., a communication module, a wireless communication module, a heat dissipation module, a substrate, a print circuit board (PCB), a flexible PCB (FPCB), a printed circuit board assembly (PBA), a module, an antenna, an antenna element, circuitry, a processor, a chip, a component, or a device), a term referring to an RF-related component (e.g., a front end module (FEM), a power amplifier module (PAM), a FEM including duplexer (FEMid), a power amplifier module including duplexer (PAMid), a Low noise amplifier PAM including duplexer (LPAMid), a radio frequency front end (RFFE), or a radio frequency integrated circuit (RFIC)), a term referring to a shape of a component (e.g., an opening region, an opening, a protrusion region, a protrusion, a construction, a structure, a support portion, or a contact portion), a term referring to a connecting portion between structures (e.g., a connecting portion, a contact portion, a support portion, a contact structure, a conductive member, or an assembly), a term referring to circuitry (e.g., a PCB, an FPCB, a signal line, a feeding line, a data line, an RF signal line, an antenna line, an RF path, an RF module, RF circuitry, a splitter, a divider, a coupler, or a combiner), and the like used in the following descriptions are exemplified for convenience of explanation. Therefore, the present disclosure is not limited to terms to be described below, and another term having an equivalent technical meaning may be used. In addition, a term such as '...unit', '...device', '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

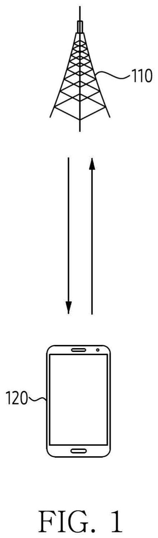

FIG. 1 illustrates a wireless communication system.

Referring to FIG. 1, FIG. 1 exemplifies a base station 110 and a terminal 120 as a portion of nodes using a wireless channel in the wireless communication system.

The base station 110 is a network infrastructure for providing wireless access to the terminal 120. The base station 110 has coverage defined based on a distance at which a signal may be transmitted. In addition to the base station, the base station 110 may be referred to as an 'access point (AP)', an 'eNodeB (eNB)', a '5th generation (5G) node', a 'next generation nodeB (gNB)', a 'wireless point', a 'transmission/reception point (TRP)', or another term having a technical meaning equivalent thereto.

The terminal 120, which is a device used by a user, performs communication with the base station 110 through the wireless channel. A link from the base station 110 to the terminal 120 is referred to as a downlink (DL), and a link from the terminal 120 to the base station 110 is referred to as an uplink (UL). In addition, although not illustrated in FIG. 1, the terminal 120 and another terminal may perform communication with each other through a wireless channel between them. At this time, a link (a device-to-device link (D2D)) between the terminal 120 and the other terminal is referred to as a sidelink, and the sidelink may be used interchangeably with a PC5 interface. In some other embodiments, the terminal 120 may be operated without involvement of a user. According to an embodiment, the terminal 120, which is a device that performs machine type communication (MTC), may not be carried by a user. In addition, according to an embodiment, the terminal 120 may be a narrowband (NB)-internet of things (IoT) device.

In addition to a terminal, the terminal 120 may be referred to as a 'user equipment (UE)', a 'customer premises equipment (CPE)', a 'mobile station', a 'subscriber station', a 'remote terminal', a 'wireless terminal', an 'electronic device', a 'user device', or another term having a technical meaning equivalent thereto.

Conventionally, in a communication system in which a cell radius of a base station is relatively large, each base station has been installed such that each base station includes a function of a digital processing unit (or distributed unit (DU)) and a radio frequency (RF) processing unit (or radio unit (RU)). However, as a high frequency band is used in 4th generation (4G) and/or subsequent communication system (e.g., 5G) and cell coverage of a base station decreases, the number of base stations for covering a specific region has increased. An installation cost burden on an operator for installing base stations has also increased. In order to minimize an installation cost of a base station, a structure has been proposed in which one or more RUs are connected to one DU through a wired network as a DU and an RU of a base station (e.g., the base station 110) are separated and one or more RUs distributed geographically to cover a specific region are disposed.

A housing means an exterior that accommodates internal components in various devices such as an electronic device and a mechanical device. The housing is used to protect and fix components of a device. In a case of an electronic device using power such as network equipment or a mechanical device that physically moves, heat may be generated during operation. Since heat may adversely affect operation of a device, the housing is generally designed to have a structure that dissipates the heat to the outside. Recently, due to development of electronic industry, electronic components are being installed more closely to each other on a printed circuit board due to high integration of circuitry and miniaturization of equipment. In addition, according to a trend of miniaturization of electronic devices, high density and high mounting of a package including a printed circuit board, which is its core element, have emerged as an important factor. In a case that an electronic device is operated, heat may be generated from each of the electronic components on the printed circuit board. In a case that the heat generated from the electronic components on the printed circuit board is not properly dissipated to the outside, a function is degraded due to the heat, and thus there is a problem of shortening lifespan of a product. Accordingly, in order to maintain optimized performance of the electronic components mounted on the printed circuit board, it is required to maintain an environment suitable for a usage characteristic of each electronic component used in the device. A device for dispersing and dissipating heat generated inside the device is inevitably required.

Network communication equipment such as the base station 110, the terminal 120, a RAN intelligence controller (RIC), a central unit (CU), a DU, an RU, a massive multiple input multiple output (MIMO) unit (MMU), or an access unit (AU) may include multiple electronic components for generating a transmission signal to an external electronic device or processing a reception signal from an external electronic device. During operation of the network communication equipment, at least one electronic component may generate heat. The network communication equipment may have a heat dissipation structure to disperse the generated heat or to dissipate the heat to the outside. Hereinafter, in the present disclosure, a structure and related technologies for a heat dissipation structure for distributing heat generated in the network communication equipment such as the CU, the DU, the RU, the MMU, and the AU are described. Hereinafter, the network communication equipment may be referred to as an electronic device.

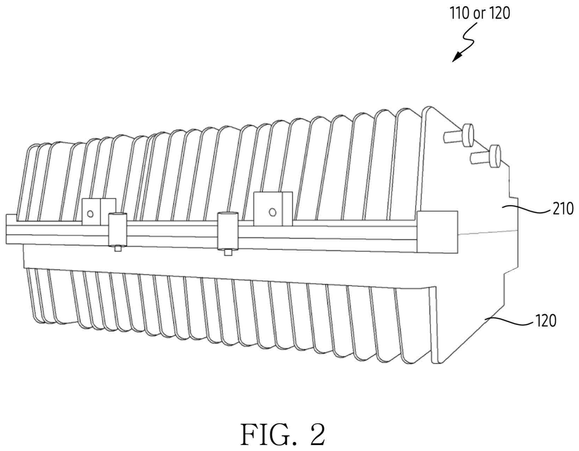

FIG. 2 illustrates an example of an external appearance of an electronic device (e.g., a base station 110, a terminal 120, a DU, an RU, an MMU, or an AU) including a heat dissipation structure.

Referring to FIG. 2, the electronic device may include a first housing 210 and a second housing 220. The first housing 210 may be referred to as an upper housing, and the second housing 220 may be referred to as a lower housing. The first housing 210 and the second housing 220 may be assembled to form an enclosed space for protecting a printed board assembly (PBA) from the outside. The PBA is an assembly of circuitry including a board and a plurality of components mounted on the board. Such as the PBA, a component disposed in an internal space formed by the first housing 210 and the second housing 220 may generate heat according to operation. For example, the operation may include a transmission signal and/or a reception signal for wireless communication and a data calculation. According to an embodiment, each of the first housing 210 and the second housing 220 may include a plurality of fins for heat dissipation. According to another embodiment, any one of the first housing 210 and the second housing 220 may not include a fin for heat dissipation.

A housing (e.g., the first housing 210 or the second housing 220) of the electronic device may protect the PBA mounted inside the electronic device from an external environment. For example, an inner side of the housing in contact with the PBA may have a shape having various heights due to various sizes of electronic components of the PBA. The outside of the housing may include a plurality of fins to dissipate heat generated from the PBA to the outside (e.g., into the air). This fin may be referred to as a heat dissipation fin. In order to effectively dissipate heat, a fin may have a plate shape having a large surface area. The electronic components in the PBA may contact a bottom side of the housing. Through this, while an electronic component is operating (e.g., while the electronic component processes a wireless signal), heat generated from the electronic component of the PBA may be dissipated into the outside air through the bottom side of the housing and the heat dissipation fin.

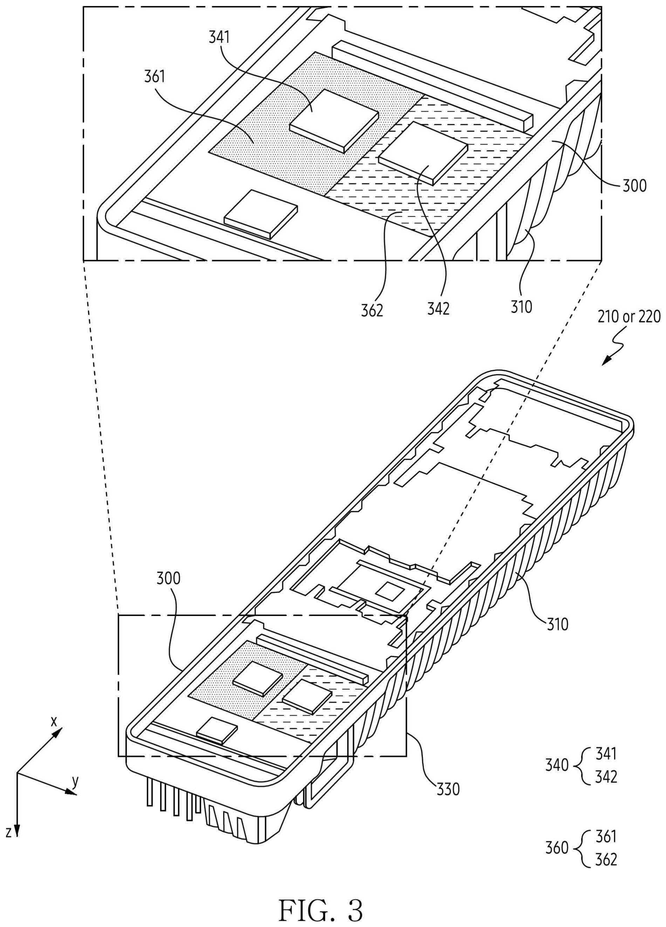

FIG. 3 illustrates an example of an electronic device (e.g., a base station 110, a terminal 120, a DU, an RU, an MMU, or an AU) including a heat dissipation structure. In FIG. 3, a cross-section inside a housing (e.g., a first housing 210 or a second housing 220) of the electronic device is described.

Referring to FIG. 3, the electronic device may include a housing 300. Multiple electronic components may be disposed inside the housing 300 of the electronic device. The housing 300 of the electronic device may protect a printed circuit board assembly (PBA) mounted inside a product from an external environment. The PBA means a substrate completed by soldering an electronic component to a printed circuit board (PCB). The PCB is an insulating substrate on which a conductive pattern (e.g., a pattern formed of a copper wire) is formed for an electrical connection of an electronic component, and the PBA may be manufactured through a connection between the electronic component and the conductive pattern. An inner side of the housing 300 in contact with the PBA may have a shape having various heights due to various heights of components above the PBA.

The outside of the housing 300 may include a heatsink 310 to dissipate heat generated from the PBA to the outside. The heatsink 310 of the housing 300 may be formed for heat dissipation. According to an embodiment, the heatsink 310 may include a plurality of fins. Each fin of the plurality of fins may be referred to as a heat dissipation fin. In order to effectively dissipate heat, the fin may have a plate shape having a large surface area. For example, the housing 300 may be manufactured by a diecasting method. The diecasting method, which is one of casting processes, not only provides high productivity, but also provides high precision as a component is manufactured using a mold. The diecasting method includes a method of manufacturing a component using various metals (e.g., aluminum, zinc, magnesium, copper, tin, lead, and iron). For example, the housing 300 may be formed of aluminum material. Aluminum is lightweight, has high thermal conductivity, and has excellent resistance to corrosion. As network communication equipment becomes highly functional and highly integrated, a demand for weight reduction of the housing 300 continues to occur. There are various methods for weight reduction of the housing 300. For example, magnesium, which has a lower specific gravity than aluminum, which is a lightweight metal, may be used, or a technique of reducing weight by thinning a fin of the housing 300 may be used. For example, in order to diffuse heat of a high-heat portion to the surroundings and dissipate it to the outside, a material with high thermal conductivity instead of aluminum may be used in the housing 300 or a separate component (e.g., a graphite sheet, a heat pipe, or a vapor chamber) having high thermal conductivity may be attached to the inner side of the housing 300.

The housing 300 may reduce an effect of the PBA or an electronic component to be corroded due to external moisture or dust. Heat generated from an electronic component may be dissipated to the outside air by a fin through an inner lateral side of the housing 300. At least some components located on or in the PBA may contact a side of the housing 300. While the electronic device is operating, heat generated from the component(s) may be dissipated into the outside air through a bottom side of the housing and a heat dissipation fin. Electronic components disposed in the PBA may have various temperature margins. For sufficient heat dissipation with respect to a high-heat component or a component with insufficient temperature margin among the electronic components, a vapor chamber 360 or a heat pipe may be used in order to spread widely heat generated from the component to a fin of the heatsink 310 of the housing 300 having a larger area. The vapor chamber 360 or the heat pipe may be disposed between an electronic component and the inner side of the housing 300. For example, an electronic component 340 (e.g., a first electronic component 341 and a second electronic component 342) may contact a side of the housing 300 through the vapor chamber 360 (or through the vapor chamber 360 and a thermal interface material (TIM) (not illustrated)) instead of directly contacting the side of the housing 300. The electronic device may include a first vapor chamber 361 for the first electronic component 341. The electronic device may include a second vapor chamber 362 for the second electronic component 342. Since the vapor chamber 360 or the heat pipe has excellent thermal conductivity, heat generated in an electronic component may be rapidly diffused to the surroundings.

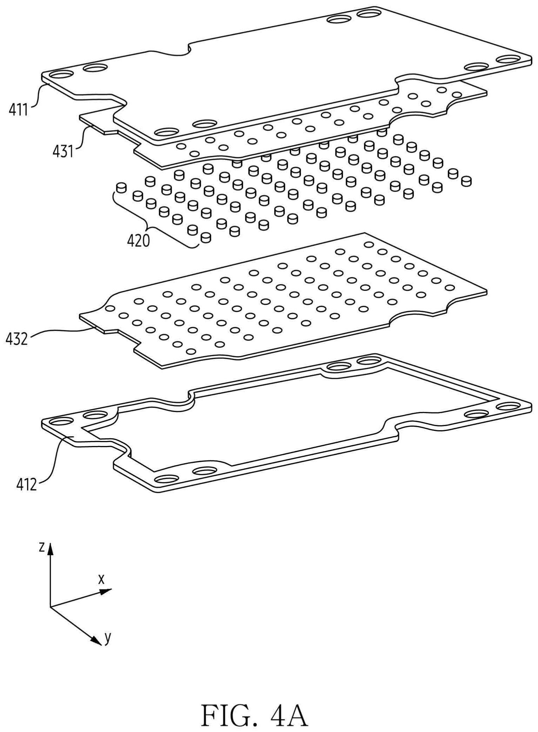

FIG. 4A is an exploded perspective view of a vapor chamber 360 of a heat dissipation structure. For the same or similar descriptions, the same reference numerals may be used.

Referring to FIG. 4A, the vapor chamber 360 may include a first cover 411, a second cover 412, a plurality of pillars 420, a first wick structure 431, and a second wick structure 432. The vapor chamber 360 may have a stacked structure. For example, in a (+) z direction, the second cover 412, the second wick structure 432, the plurality of pillars 420, the first wick structure 431, and the first cover 411 may be stacked in that order. An electronic component (not illustrated) that generates heat may be disposed under a bottom side (e.g., a side facing a (-) z direction) of the second cover 412.

The vapor chamber 360 may be used to conduct heat. Heat generated from an electronic component may be conducted in a (+) z-axis direction by the vapor chamber 360 and dissipated to the outside. The vapor chamber 360 may be formed of a metallic material and may include a fluid inside. In order to store the fluid inside, the vapor chamber 360 may include the first cover 411 and the second cover 412. The fluid may absorb heat and be converted into vapor, and the converted vapor may dissipate heat by moving to the outside of the vapor chamber 360. The vapor chamber 360 may include the plurality of pillars 420 to transfer internal heat to the outside. For example, each pillar may have a cylindrical shape. For example, each pillar may have a quadrangular column shape. For example, each pillar may have a polygonal column shape. The vapor chamber 360 may include a wick structure for improving heat diffusion and cooling efficiency. For example, the vapor chamber 360 may include at least one of the first wick structure 431 and/or the second wick structure 432. Each wick structure may have a plate shape having porosity. In order to generate a surface tension through capillary force of a fluid, a wick structure may be disposed on each of a side of the first cover 411 and a side of the second cover 412.

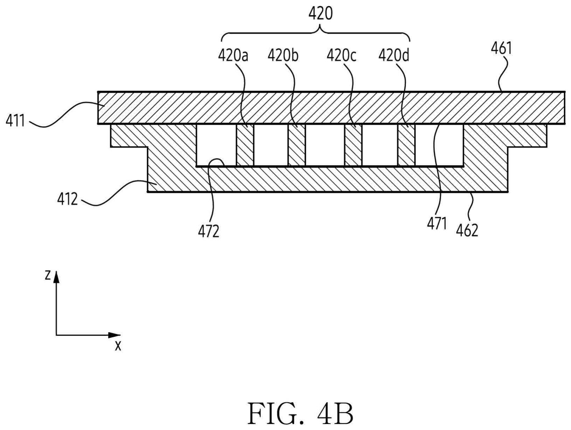

FIG. 4B is a cross-sectional view of a vapor chamber of a heat dissipation structure. In FIG. 4B, a cross-sectional view of the vapor chamber 360 of FIG. 4A viewed in a (-) y-axis direction is exemplified. For the same or similar descriptions, the same reference numerals may be used.

Referring to FIG. 4B, the vapor chamber 360 may include a structure stacked in a (+) z-axis direction. The first cover 411 may be disposed above the second cover 412. The first cover 411 and the second cover 412 may be formed of a metal providing thermal conductivity greater than a specified threshold value. For example, each of the first cover 411 and the second cover 412 may be formed of copper. As an example, thermal conductivity of copper is approximately 401 W/watts per meter-kelvin (m·K). It may be conducted in the (+) z-axis direction and dissipated to the outside by the vapor chamber 360. For example, a first side 461 of the first cover 411 may face the (+) z-axis direction. A second side 471 of the first cover 411 opposite to the first side 461 of the first cover 411 may face a (-) z-axis direction. A first side 462 of the second cover 412 may face the (-) z-axis direction. Heat generated from an electronic component may be transferred to the first side 462 of the second cover 412. A second side 472 of the second cover 412 opposite to the first side 462 of the second cover 412 may face the (+) z-axis direction. A region of the second side 472 of the second cover 412 may contact the first cover 411. Another region of the second side 472 of the second cover 412 may contact the plurality of pillars 420 (e.g., a pillar 420a, a pillar 420b, a pillar 420c, and a pillar 420d).

The plurality of pillars 420 may be disposed in a space between the first cover 411 and the second cover 412. A fluid (e.g., water) for absorbing heat may be disposed in the space. The plurality of pillars 420 may be formed of a metallic material to effectively transfer heat transferred from the second cover 412 to the first cover 411. For example, the plurality of pillars 420 may be formed of a copper material.

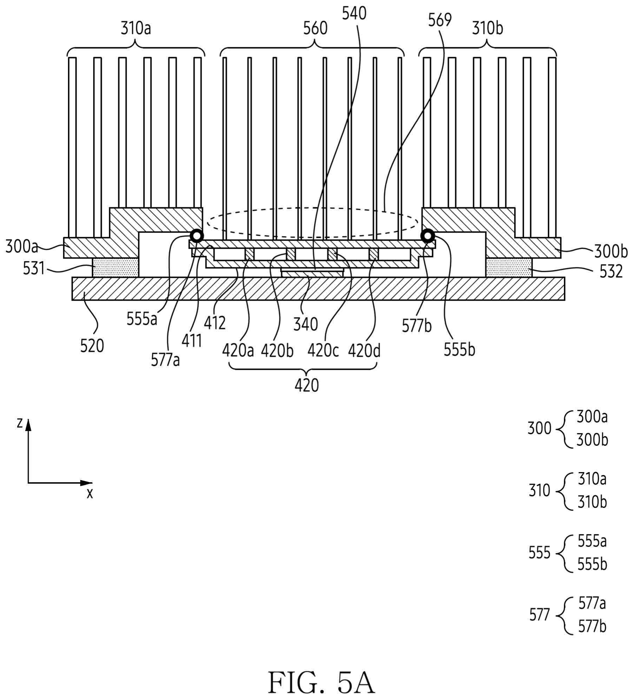

FIG. 5A illustrates a cross-sectional view of an electronic device including a heat dissipation structure. For the same or similar descriptions, the same reference numerals may be used.

Referring to FIG. 5A, the electronic device may include a housing 300. The housing 300 may include a first housing part 300a and a second housing part 300b. For example, the housing 300 may include a plurality of portions. As an example, the housing 300 may be integrally formed, and may be viewed as a separate form on the cross-sectional view. As another example, the housing 300 may include a plurality of physically separated portions. The housing 300 may be configured to dissipate heat generated from each electronic component to the outside. The housing 300 may include a heatsink 310. The heatsink 310 may include fins 310a and fins 310b. The fins 310a may be disposed above a side of the first housing part 300a. The fins 310b may be disposed on a side of the second housing part 300b. Each fin of the fins 310a and the fins 310b may have a plate shape. Each fin of the fins 310a and the fins 310b may be configured to cool the generated heat by being exposed to the air due to an electronic device disposed outdoors. The fins 310a and the fins 310b may be formed with the housing 300 by a diecasting method.

The electronic device may include a PCB 520. The PCB 520 may be configured as a PBA by being coupled with an electronic component configured in a form of a circuit. Multiple electronic components may be disposed above a side of the PCB 520. For example, an electronic component 531 and an electronic component 532 may be disposed above the side of the PCB 520. The electronic component 531 and the electronic component 532 may contact the housing 300. As an example, the electronic component 531 may contact an inner side of the first housing part 300a. The electronic component 532 may contact an inner side of the second housing part 300b. Since an inner side of the housing 300 contacts each electronic component, heat generated from the corresponding electronic component may be transferred to the housing 300. Heat is dissipated to the outside through the fins (e.g., the fins 310a and the fins 310b) of the heatsink 310. A power margin of the electronic component 531 or the electronic component 532 may be higher than a power margin of an electronic component 340 to be described later. This is because a heat dissipation structure using only the housing provides low heat dissipation performance. For example, the electronic component 531 or the electronic component 532 may be a module (e.g., an RFFE, an FEM, an FEMid, a PAMid, or an LPAMid) or a chip including a power amplifier.

The electronic device may include the PCB 520. The PCB 520 may be configured as the PBA by being coupled with the electronic component configured in the form of the circuit. The multiple electronic components may be disposed above the side of the PCB 520. For example, the electronic component 340 may be disposed above the side. Heat generated from the electronic component 340 may be dissipated through a vapor chamber 360. The heat may contact the vapor chamber 360 and may spread to the surroundings as much as an area of the vapor chamber 360. A power margin of the electronic component 340 may be relatively lower than a power margin of the electronic component 531 or the electronic component 532. For example, the electronic component 340 may include a processor, a central processing unit (CPU), a graphical processing unit (GPU), an application processor (AP), a communication processor (CP), or a field-programmable gate array (FPGA). If the electronic component 340 and the vapor chamber 360 are in direct contact with each other, an interface due to component tolerance may inevitably occur. In order to improve thermal resistance, a terminal interface material (TIM) 540 may be disposed between the electronic component 340 and the vapor chamber 360. For example, the TIM 540 may include a thermal pad, gel, or grease. Since the TIM 540 comprises a metal and a ceramic particle having a thermal conductivity characteristic based on a polymer material, mechanical tolerance may be lowered and thermal conductivity at an interface may be increased due to the disposition of the TIM 540.

Unlike FIG. 5A, a disposition of a TIM between the vapor chamber 360 and an inner lateral side of the housing 300 may be considered. However, the TIM has thermal conductivity of approximately 20 to 30 W/(m·K), and since higher thermal conductivity results in higher cost and since there are a pressing condition and reuse, the disposition of the TIM is mechanically limited. For example, fin molding of the heatsink 310 of the housing 300 may be manufactured through a diecasting method. The diecasting method has an advantage of molding a complex internal shape of the housing 300 and the heatsink 310 at a low cost, but a certain level of a fin thickness and a disposition interval are required in order to prevent breakage or deformation of a fin when extracting a product molded in a diecasting mold from the mold. In addition, as heat generation of a component increases, a longer fin length is required to improve heat dissipation performance. In other words, as heat generation of the component increases, a heat dissipation fin is required to be thicker and longer. However, a volume and a weight of the electronic device increase as the dissipation fin becomes thicker and longer, it is not advantageous in terms of weight reduction of the electronic device.

In order to solve the above-described problem, at least a portion of the housing 300 may include an opening region 569. A side (e.g., a first side 461 of a first cover 411 or a coated layer) of the vapor chamber 360 may be exposed to the outside through at least a portion of the opening region 569 of the housing 300. Both a structure in which an aluminum sheet disposed above a copper vapor chamber is disposed or a structure in which a coating layer is formed on a side of the vapor chamber may be understood as implementation of the vapor chamber 360. In other words, the aluminum sheet being exposed through the opening region 569 may also be included in an embodiment of the present disclosure. Heat dissipation fins 560 may be disposed on the exposed side of the vapor chamber 360. The heat dissipation fins 560 may be bonded through welding to the side of the vapor chamber 360. Unlike the heat dissipation fins formed integrally with the housing 300 through the diecasting method, as it is separately manufactured and then disposed through a welding process, it may allow the electronic device to have a wider interval margin and a thinner thickness than the heat dissipation fins of the heatsink 310. Hereinafter, for convenience of explanation, the heat dissipation fins of the heatsink 310 of the housing 300 may be referred to as first fins. The heat dissipation fins 560 formed on the side of the vapor chamber 360 may be referred to as second fins.

The second fins may be disposed on the side of the vapor chamber 360, and the first fins may be disposed on a side of the heatsink 310 of the housing 300. For example, 12 types of aluminum die casting (ADC) or 3 types of ADC may be used for an aluminum material used for diecasting molding of the housing 300. The aluminum material generally has thermal conductivity of approximately 90 to 160 W/(m·K). For the second fins attached to the vapor chamber 360, a material having high thermal conductivity of approximately 170 to 210 W/(m·K) may be used, such as AL1050, AL1070, AL3003, and AL6063. Since the first fins are formed together with the housing 300 through the diecasting method, a thickness and a disposition are limited. However, since the second fins attached to the vapor chamber 360 are manufactured separately other than the diecasting method, they may be formed in a form of a sheet with a relatively thin thickness. In addition, as a certain thickness is not required, a weight of each fin may be reduced. Due to the opening region 569 of the housing 300, a thickness of a side of the housing 300 may be removed. The thickness of the side of the housing 300 is approximately 3 to 4 mm. Since the vapor chamber 360 replaces the housing 300, a weight of the housing 300 may be reduced. In addition, since a length of the second fin may be increased by the thickness to be removed, the second fin may provide more advantageous heat dissipation performance.

The vapor chamber 360 may replace a portion of the housing 300. For example, when viewed from above in a (-) z-axis direction, the vapor chamber 360 and the housing 300 may be assembled so that an edge portion 577 of the vapor chamber 360 overlaps the housing 300. In order to prevent foreign substances such as external moisture and dust from penetrating into a space formed by the housing 300, the PCB 520, and the vapor chamber 360, an additional structure may be disposed between the edge portion 577 and the housing 300. For example, a gasket 555 may be disposed between the edge portion 577 and the housing 300. For example, a screw may be disposed between the edge portion 577 and the housing 300 to fix the vapor chamber 360 to the housing 300. The gasket 555 may be formed of a polymer material (e.g., silicon) with an elastic characteristic. For example, the gasket 555 is required to have surface hardness of Shore A 20 or more. The elastic characteristic of the gasket 555 may maintain tolerance between the vapor chamber 360 and an electronic component 320 below a certain level, thereby functioning to reduce thermal resistance in the TIM. Additionally, in order to reduce the tolerance between the vapor chamber 360 and the electronic component 340, a screw (not illustrated) with an added spring may be used.

The first cover 411 and/or a second cover 412 of the vapor chamber 360 may be formed of a copper material. Copper has high thermal conductivity, and a working fluid with excellent cooling efficiency may be disposed inside the vapor chamber 360. For example, water may be used as the working fluid of the vapor chamber 360. Water is chemically stable and has high latent heat, so provides an advantage of excellent heat dissipation. However, in a case that the working fluid is water, hydrogen gas may be generated due to a reaction between water and aluminum, and a problem of reduced heat dissipation performance may occur. Since stability is low, the first cover 411 and/or the second cover 412 of the vapor chamber 360 may be formed of the copper material. For another example, other working fluids (acetone, ammonia, and hydrochlorofluorocarbons (HCFCs), hydrofluorocarbons (HFCs), and the like) may be used as a fluid other than water. Since network communication equipment is mostly installed and used in an outdoor environment, there is a risk of corrosion if the copper material is directly exposed to the outside. Therefore, in the vapor chamber 360 according to embodiments of the present disclosure, plating or painting coating for corrosion prevention may be additionally performed on the side (e.g., the first side 461 of the first cover 411) of the vapor chamber 360 to which the heat dissipation fins 560 are bonded. A side of the first cover 411 of the vapor chamber 360 may include a coating layer.

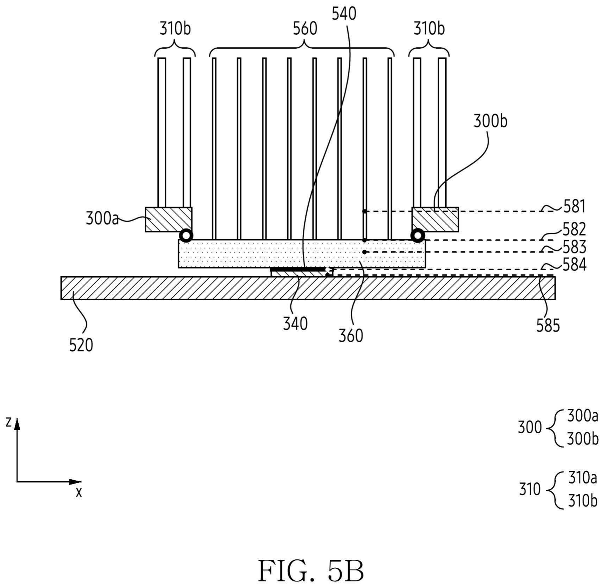

FIG. 5B illustrates an example of elements in which heat is dispersed. For the same or similar descriptions, the same reference numerals may be used. In FIG. 5B, each thermal resistance in the heat dissipation structure of the electronic device of FIG. 5A is described.

Referring to FIG. 5B, a PCB 520, an electronic component 340, a TIM 540, a vapor chamber 360, and heat dissipation fins 560 may be disposed in that order. Heat generated from the electronic component 340 may be conducted in a (+) z-axis direction and dissipated to the outside. Fins of a heatsink 310 and the heat dissipation fins 560 may dissipate heat due to influence of air wind. On a path through which heat generated from an electronic component is conducted, thermal resistance R_{JC} 581 of the electronic component 340, thermal resistance R_{TIM} 582 of the TIM 540, thermal resistance R_{vC} 583 of the vapor chamber 360, thermal resistance R_{welding} 584 of a welding layer, and thermal resistance R_{fin} 585 of the heat dissipation fins 560 may be located. Since the vapor chamber 360 and the heatsink 310 do not directly contact each other, thermal resistance of a TIM between the vapor chamber 360 and the heatsink 310 may be ignored. In addition, without thermal resistance due to a thickness of the housing 300, a path transferred through the welding layer and the heat dissipation fins 560 from the vapor chamber 360 may have lower thermal resistance than a path transferred through a contact with the housing 300. Due to low thermal resistance, a heat dissipation structure in which the vapor chamber 360 and the heat dissipation fins 560 are coupled may provide improved heat dissipation performance.

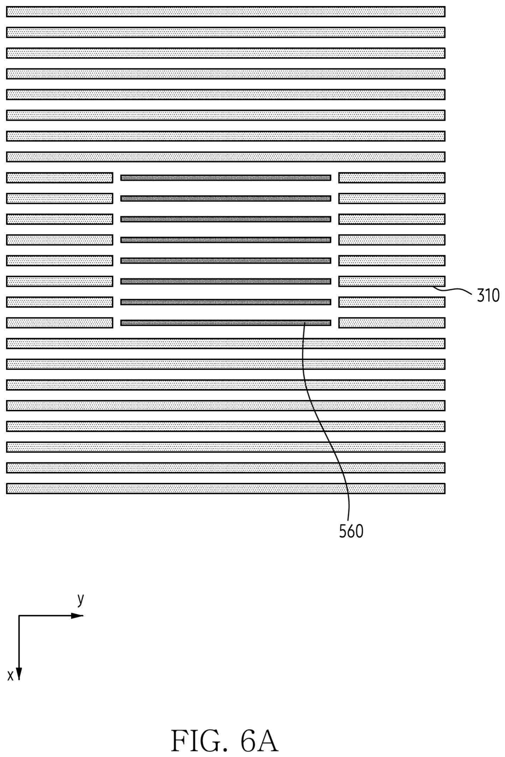

FIGS. 6A to 6B illustrate examples of dispositions of a plurality of fins for heat dissipation. In FIGS. 6A to 6B, a disposition of the heat dissipation structures of FIGS. 5A to 5B viewed from a (+) z-axis direction to a (-) z-axis direction is illustrated. For the same or similar descriptions, the same reference numerals may be used.

Referring to FIG. 6A, a heatsink 310 of a housing 300 may include a plurality of first fins. Heat dissipation fins 560 (i.e., second fins) may be disposed above a side of a vapor chamber 360. A thickness of each fin of the heat dissipation fins 560 may be thinner than each thickness of the first fin. Unlike the first fin formed with the housing 300 through a diecasting method, the second fin is separately manufactured, and thus may have a shape of a sheet having a relatively thin thickness. As an example, the thickness of the first fin formed through the diecasting method may have a thickness of approximately 1.64 mm and an interval between fins of approximately 13 mm. The second fin formed as the sheet may have a thickness of approximately 0.5 to 1.0 mm and an interval between fins of approximately 5 to 10 mm.

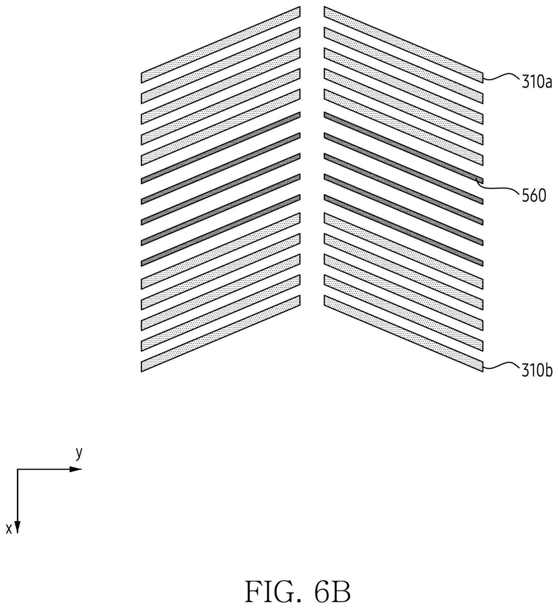

In FIG. 6A, a disposition in which surfaces of the first fins and the second fins are aligned to face an x-axis direction is illustrated, but embodiments of the present disclosure are not limited thereto. According to variety of wind directions, fins may be aligned such that a surface of each fin faces various directions. For example, referring to FIG. 6B, at least a portion of the fins may be disposed in a direction inclined from an x-axis to a (-) y-axis, and a remaining portion of the fins may be disposed in a direction inclined from the x-axis to a (+) y-axis.

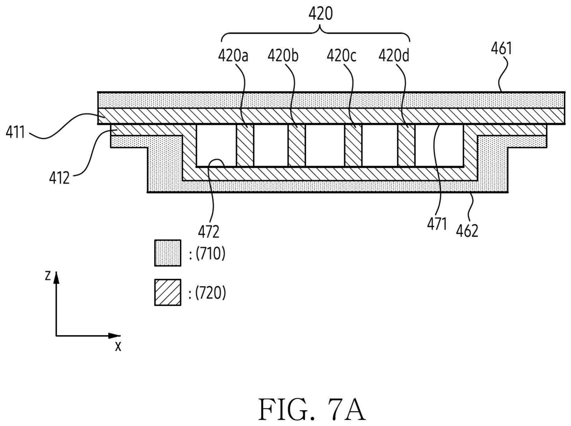

FIG. 7A illustrates an example of a vapor chamber 360 comprising a plurality of metallic materials. In FIG. 7A, an example in which the vapor chamber 360 of FIG. 4A is formed of a plurality of metallic materials is described. A metal may have various properties according to a type. A metal has various ionization tendencies according to a type. The ionization tendency indicates a degree to which a metal is easily ionized, and a metal with a high ionization tendency easily loses an electron and becomes an ion, and on the contrary, a metal with a low ionization tendency is difficult to lose an electron and thus difficult to become an ion. For example, ionization tendency of aluminum is higher than an ionization tendency of copper. In addition, a metal has various thermal conductivity according to a type. For example, thermal conductivity of copper or silver is higher than thermal conductivity of aluminum. For the same or similar descriptions, the same reference numerals may be used.

Referring to FIG. 7A, a clad in which a first metallic material 710 and a second metallic material 720 are bonded may be used to form a vapor chamber 360. The clad is a material formed by bonding two or more metals. An advantage of each metal may be obtained through the clad, it may be used in various fields. The first metallic material 710 may form an outer side of the vapor chamber 360. The second metallic material 720 may form an inner side of the vapor chamber 360. An ionization tendency of the first metallic material 710 may be higher than an ionization tendency of the second metallic material 720. The first metallic material 710 having a high ionization tendency may form an oxide film by reacting with oxygen in the air. Due to the oxide film, oxidation resistance increases, and corrosion may be prevented. For example, the first metallic material 710 may comprise aluminum. The second metallic material 720 may comprise copper. That is, the clad may be an aluminum-copper clad. For example, the aluminum-copper clad may have a thickness of approximately 0.3 to 1.5 millimeter (mm), a thickness ratio of the copper may be approximately 30 to 50%, and a thickness ratio of the aluminum may be approximately 50 to 70%. The aluminum-copper clad may be used as a material for each of a first cover 411 and a second cover 412.

A first substrate 711 may be formed of a material of the aluminum-copper clad. A second side 471 of the first substrate 711 may be a copper side. A second substrate 712 may be formed of a material of the aluminum-copper clad. A second side 472 of the second substrate 712 may be a copper side. Since a copper side is located on an inner side other than an outer side, the copper is not exposed to the air, and thus the vapor chamber 360 may provide a robust characteristic against internal corrosion. As the second side 471 of the first substrate 711 and the second side 472 of the second substrate 712 are bonded to face each other, a space surrounded by copper may be formed. A working fluid (e.g., water) may be disposed inside the space. Since the first metallic material 710 (e.g., aluminum) is disposed outside the vapor chamber 360, it may be easy to dispose heat dissipation fins (e.g., heat dissipation fins 560) having the first metallic material 710. Due to the same type of metallic material, unnecessary processing may be eliminated during welding, and thermal resistance due to welding (e.g., thermal resistance 584) may also be reduced. Additional painting coating may be performed such that a side (e.g., the first side 461 of the first substrate 411) exposed to the outside is more robust in the air. Since heat dissipation performance is maintained through a coating layer, an electronic device may be used for a long time in a state of being exposed to an outdoor environment.

Instead of forming a vapor chamber only with a single metallic material (e.g., copper), a vapor chamber may be formed through a clad in which a metallic material (e.g., aluminum) with a lower specific gravity than the metallic material and the metallic material are combined. Due to the metallic material with the low specific gravity, weight reduction of the vapor chamber may be achieved. For example, the first cover 411 and the second cover 412 of the vapor chamber may be formed by the aluminum-copper clad in which aluminum and copper are combined. According to an embodiment, a vapor chamber of which at least a portion is exposed through the opening region 569 of FIG. 5A may be formed through the aluminum-copper clad. Meanwhile, as illustrated in FIG. 7A, the vapor chamber itself formed through the aluminum-copper clad may be understood as an embodiment of the present disclosure. In other words, even if a housing 300 covers the vapor chamber without the opening region 569 of FIG. 5A, a structure including the vapor chamber formed through the aluminum-copper clad and an electronic device including the structure may be understood as an embodiment of the present disclosure.

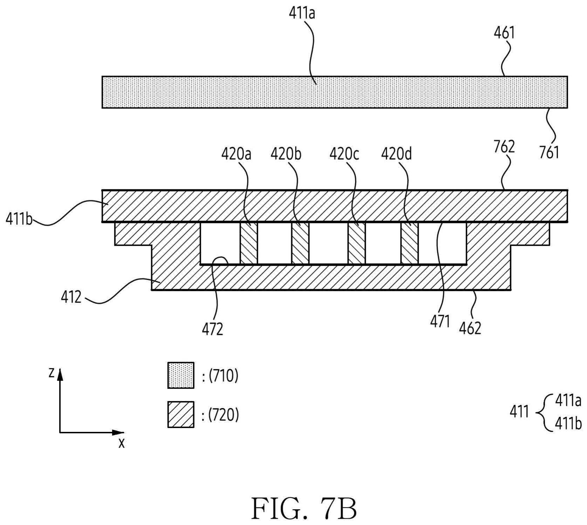

FIG. 7B illustrates another example of a vapor chamber 360 comprising a plurality of metallic materials. In FIG. 7B, an example in which the vapor chamber 360 of FIG. 4A is formed of a plurality of metallic materials is described. A metal may have various properties according to a type. A metal has various ionization tendencies according to a type. In addition, a metal has various thermal conductivity according to a type.

Referring to FIG. 7B, a first cover 411 of the vapor chamber 360 may include a first portion 411a having a first metallic material 710 and a second portion 411b having a second metallic material 720. For example, the first cover 411 may include a clad in which dissimilar metallic materials are combined. A side 761 of the first portion 411a may be coupled to a side 762 of the second portion 411b. The side 761 of the first portion 411a may be opposite to a first side 461 of the first cover 411. The side 762 of the second portion 411b may be opposite to a second side 471 of the first cover 411.

According to an embodiment, the first metallic material 710 may comprise aluminum. The second metallic material 720 may comprise copper. For example, in a product state of a copper vapor chamber, an aluminum sheet may be bonded to one copper side (e.g., the side 762 of the second portion 411b). In other words, the vapor chamber 360 may include the copper vapor chamber and the aluminum sheet (e.g., the first portion 411a of the first cover 411). For example, the first cover 411 may include a copper-aluminum clad. Since the copper vapor chamber is formed of one product and forms a space with a single material, the vapor chamber 360 may guarantee its original function of evaporating a working fluid to transfer heat. Aluminum is robust against oxygen corrosion, but has a weak characteristic due to lower heat dissipation performance and explosion in reaction with water. On the other hand, copper is vulnerable to oxygen corrosion, but it has a strong characteristic in water. Therefore, as the aluminum sheet is located in a portion exposed to the outside, and an inner space for storing a fluid (e.g., water) is formed of copper, the vapor chamber 360 may be stably formed. In addition, since a specific gravity of aluminum is lower than a specific gravity of copper, a volume and a weight of the vapor chamber 360 may be formed more efficiently. As a thickness of copper may be reduced through reinforcement of a strength of the added aluminum sheet, the vapor chamber 360 of FIG. 7B may be lighter than a vapor chamber formed of only copper.

In FIG. 7B, the vapor chamber formed of copper and the vapor chamber including the aluminum sheet (e.g., the first portion 411a of the first cover 411) has been described as an example, but embodiments of the present disclosure are not limited thereto. According to an embodiment, instead of the aluminum sheet, a sheet having another metallic material (e.g., a metal having a stronger characteristic against oxidation corrosion than copper) may be used.

Instead of forming a vapor chamber only with a single metallic material (e.g., copper), a metallic material (e.g., aluminum) with a lower specific gravity than the metallic material may be used to form the vapor chamber instead of the metallic material. Due to the metallic material with the low specific gravity, weight reduction of the vapor chamber may be achieved. This is because a thickness of a copper portion in a heat dissipation structure decreases as aluminum is used. For example, an aluminum sheet may be coupled to a copper vapor chamber. The first cover 411 of the vapor chamber may include a bonding structure of aluminum and copper. According to an embodiment, a vapor chamber of which at least a portion is exposed through the opening region 569 of FIG. 5A may include the vapor chamber of FIG. 7B. Meanwhile, as illustrated in FIG. 7B, the vapor chamber itself in which an aluminum sheet is bonded instead of a copper portion of an upper side of an existing vapor chamber may be understood as an embodiment of the present disclosure. In other words, even if a housing 300 covers the vapor chamber without the opening region 569 of FIG. 5A, a structure including the vapor chamber formed through the bonding and an electronic device including the structure may be understood as an embodiment of the present disclosure.

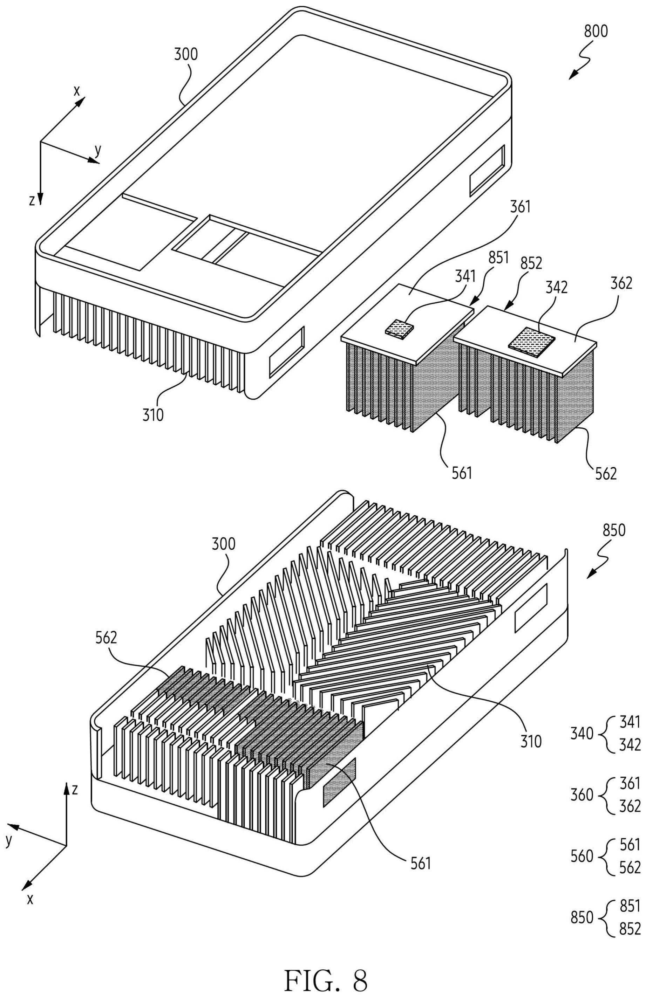

FIG. 8 illustrates an example of an electronic device (e.g., a base station 110, a terminal 120, a DU, an RU, an MMU, and an AU) including a heat dissipation structure. In FIG. 8, a cross-section inside a housing (e.g., a first housing 210 or a second housing 220) of the electronic device is described.

Referring to FIG. 8, the electronic device may include a housing 300. A perspective view 800 indicates an example in which first fins of a heatsink 310 of the housing 300 are disposed downward. The first fins of the heatsink 310 may have a length toward a (+) z-axis direction, and each fin may have a plate shape. The first fins of the heatsink 310 may have a first thickness. An interval between the first fins may be a first length. Multiple electronic components may be disposed inside the housing 300 of the electronic device. The housing 300 of the electronic device may protect electronic components or a PBA including an electronic component from an external environment.

The electronic device may include a plurality of modules (e.g., a first module 851 and a second module 852). Each module of the plurality of modules may include a heat dissipation structure. Each module may be referred to as a heat dissipation module, a communication module, a fin module, a heatsink module, or a term having a technical meaning equivalent thereto. For example, the first module 851 may include an electronic component 341, a vapor chamber 361, and heat dissipation fins 561. The second module 852 may include an electronic component 342, a vapor chamber 362, and heat dissipation fins 562. The heat dissipation fins 561 and the heat dissipation fins 562 (hereinafter, second fins) may have a second thickness. An interval between the second fins may be a second length. Unlike the first fin formed by a diecasting method, the second fin may be formed through a separate sheet, and the formed second fin may be welded and attached to a side of a vapor chamber. Since it has a relatively sufficient margin, the second thickness may be thinner than the first thickness. In addition, the second length may be shorter than the first length. In other words, the second fins may be disposed more densely in a limited space than the first fins. As a result, heat dissipation performance is increased, and since the second fin is directly bonded to the vapor chamber 360 without the housing 300, communication equipment may be lightened.

According to embodiments of the present disclosure, the electronic device, which is an outdoor-type enclosure, relates to a heat dissipation device used in various communication equipment such as a mobile communication base station (e.g., a DU, an RU, or an MMU), and a repeater (e.g., a high power amplifier (HPA), low power amplifier (LPA), and the like). Heat of an electronic component may be dissipated to the outside through fins (e.g., heat dissipation fins 560) exposed to the air. Meanwhile, a specific material (e.g., aluminum) may be applied to a heat dissipation fin or a coating layer of a vapor chamber so as to be robust against corrosion when used for a long time under a condition of exposure to an external environment. In addition, thinning a thickness of the heat dissipation fin causes a decrease in heat dissipation performance, and as a result, a total volume of communication equipment may increase. Unlike the diecasting method of the heatsink 310 integrally formed with the housing 300, the heat dissipation structure according to embodiments of the present disclosure enables a heat dissipation fin to be thinner than and have a height longer than a heat dissipation fin of the heatsink 310 by directly attaching separately manufactured heat dissipation fins to a side of the vapor chamber 360. As a thickness of a fin decreases, more heat dissipation fins may be disposed, and as each fin is formed longer, heat dissipation performance may be improved. As a region of the housing 300 is opened to expose a side of the vapor chamber 360, communication equipment may be lightened.

The effects that may be obtained from the present disclosure are not limited to those described above, and any other effects not mentioned herein will be clearly understood by those having ordinary knowledge in the art to which the present disclosure belongs, from the following description.

According to embodiments of the present disclosure, an electronic device is provided. The electronic device may comprise a housing including a plurality of first fins, a plurality of second fins, a vapor chamber including a first cover, a second cover, and a plurality of pillars, an electronic component, and a printed circuit board (PCB). The housing may include at least one heatsink portion forming an opening region. The vapor chamber may be disposed such that at least a portion of a first side of the first cover of the vapor chamber is exposed through the opening region. The plurality of second fins may be disposed on the exposed at least the portion of the first side of the first cover. The electronic component may be disposed on a side of the printed circuit board. The electronic component may be disposed in a space between a first side of the second cover facing the side of the printed circuit board and the side of the printed circuit board.

According to an embodiment, a thickness of a second fin among the plurality of second fins may be thinner than a thickness of a first fin among the plurality of first fins.

According to an embodiment, the plurality of pillars may be disposed between the first cover and the second cover. A fluid may be disposed in a space between the first cover, the second cover, and the plurality of pillars.

According to an embodiment, the vapor chamber may comprise a first wick structure coupled to a second side of the first cover opposite to the first side of the first cover and a second wick structure coupled to a second side of the second cover opposite to the first side of the second cover.

According to an embodiment, the first wick structure may include a plurality of first holes for the plurality of pillars. The second wick structure may include a plurality of second holes for the plurality of pillars.

According to an embodiment, an upper cover coupled to the second side of the first cover opposite to the first side of the first cover may be further comprised. The plurality of pillars may be disposed between the upper cover and the second cover. The first cover may be formed of a first metallic material. The upper cover may be formed of a second metallic material different from the first metallic material.

According to an embodiment, the first metallic material may comprise aluminum. The second metallic material may comprise copper.

According to an embodiment, the first cover may comprise a first clad metal formed of a first metallic material and a second metallic material. The second cover may comprise a second clad metal formed of the first metallic material and the second metallic material.

According to an embodiment, the first metallic material may comprise aluminum. The second metallic material may comprise copper.

According to an embodiment, the first side of the first cover may comprise the first metallic material of the first clad metal. The first side of the second cover may comprise the first metallic material of the second clad metal. A second side of the first cover opposite to the first side may comprise the second metallic material of the first clad metal. A second side of the second cover opposite to the first side may comprise the second metallic material of the second clad metal.

According to an embodiment, the electronic device may further comprise a thermal interface material (TIM). The TIM may be in contact with the electronic component and the first side of the second cover.

According to an embodiment, the electronic device may further comprise at least one electronic component disposed on the side of the printed circuit board. The at least one electronic component may be disposed to contact the housing. A temperature margin for the at least one electronic component may be higher than a temperature margin for the electronic component.

According to an embodiment, the electronic component may include at least one of at least one processor, a central processing unit (CPU), or a field programmable gate array (FPGA). The at least one electronic component may include a component having a power amplifier.

According to an embodiment, the electronic device may further comprise a gasket. A region of the first side of the first cover that is different from the exposed at least the portion of the first side of the first cover, may be coupled to the housing through the gasket.

According to an embodiment, the electronic device may comprise a radio unit (RU), a distributed unit (DU), a digital unit (DU), or a massive multiple input multiple output (MIMO) unit (MMU).

According to an embodiment, the plurality of first fins may be disposed on a side of the at least one heatsink portion. The plurality of first fins and the plurality of second fins may protrude in a direction in which the first side of the first cover faces. Each first fin of the plurality of first fins may have a plate shape. Each second fin of the plurality of second fins may have a plate shape. The first cover of the vapor chamber may include a coating layer. The coating layer may include the exposed at least the portion of the first side of the first cover.

According to embodiments of the present disclosure, an electronic device is provided. The electronic device may comprise a housing including a plurality of first fins, a plurality of modules, and a printed circuit board (PCB). Each module among the plurality of modules may comprise a plurality of second fins, a vapor chamber including a first cover, a second cover, and a plurality of pillars, and an electronic component. The housing may include at least one heatsink portion forming an opening region. The vapor chamber may be disposed such that at least a portion of a first side of the first cover of the vapor chamber is exposed through the opening region. The plurality of second fins may be disposed on the exposed at least the portion of the first side of the first cover. The electronic component may be disposed on a side of the printed circuit board. The electronic component may be disposed in a space between a first side of the second cover facing the side of the printed circuit board and the side of the printed circuit board.

According to an embodiment, a thickness of a second fin among the plurality of second fins may be thinner than a thickness of a first fin among the plurality of first fins.

According to an embodiment, the housing may be formed based on a first metallic material. The vapor chamber of each module among the plurality of modules may be formed based on the first metallic material and a second metallic material. The first side of the first cover may comprise the first metallic material. At least a portion of the second cover may comprise the second metallic material. The first metallic material may comprise aluminum. The second metallic material may comprise copper.

According to an embodiment, the electronic device may further comprise a gasket. A region of the first side of the first cover that is different from the exposed at least the portion of the first side of the first cover, may be coupled to the housing through the gasket.

According to embodiments of the present disclosure, a vapor chamber is provided. The vapor chamber may comprise a first metal structure and a second metal structure. The second metal structure may be coupled to the first metal structure and may form a space for a fluid between the first metal structure and the second metal structure. The vapor chamber may comprise a plurality of pillars disposed in the space. The first metal structure may be formed based on a clad in which a first metallic material and a second metallic material are combined. The second metal structure may be formed based on a clad in which the first metallic material and the second metallic material are combined. The first metal structure may be disposed such that the first metallic material is located at a first side of the first metal structure and the second metallic material is located at a second side of the first metal structure opposite to the first side. The second metal structure may be disposed such that the first metallic material is located at a first side of the second metal structure and the second metallic material is located at a second side of the second metal structure opposite to the first side. At least a portion of the second side of the first metal structure may be coupled to at least a portion of the second side of the second metal structure. The first metallic material may comprise aluminum. The second metallic material may comprise copper.

According to embodiments of the present disclosure, a vapor chamber is provided. The vapor chamber may comprise a first metal structure and a second metal structure. The second metal structure may be coupled to the first metal structure and may form a space for a fluid between the first metal structure and the second metal structure. The vapor chamber may comprise a plurality of pillars disposed in the space. The vapor chamber may comprise a third metal structure. The third metal structure may be formed based on a first metallic material. The first metal structure and the second metal structure may be formed based on a second metallic material. A first side of the first metal structure may be coupled to the third metal structure. At least a portion of a second side opposite to the first side of the first metal structure may be coupled to at least a portion of the second metal structure. The first metallic material may comprise aluminum. The second metallic material may comprise copper.

In the above-described specific embodiments of the present disclosure, components included in the disclosure are expressed in the singular or plural according to the presented specific embodiment. However, the singular or plural expression is selected appropriately according to a situation presented for convenience of explanation, and the present disclosure is not limited to the singular or plural component, and even components expressed in the plural may be configured in the singular, or a component expressed in the singular may be configured in the plural.

According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be executed sequentially, in parallel, repeatedly, or heuristically, or one or more of the operations may be executed in a different order or omitted, or one or more other operations may be added.

Meanwhile, specific embodiments have been described in the detailed description of the present disclosure, and of course, various modifications are possible without departing from the scope of the present disclosure.

## Claims

1. An electronic device comprising:
a housing including a plurality of first fins;
a plurality of second fins;
a vapor chamber including a first cover, a second cover, and a plurality of pillars;
an electronic component; and
a printed circuit board (PCB),
wherein the housing includes at least one heatsink portion forming an opening region,
wherein the vapor chamber is disposed such that at least a portion of a first side of the first cover of the vapor chamber is exposed through the opening region,
wherein the plurality of second fins are disposed on the exposed at least the portion of the first side of the first cover,
wherein the electronic component is disposed on a side of the printed circuit board, and
wherein the electronic component is disposed in a space between a first side of the second cover facing the side of the printed circuit board and the side of the printed circuit board.

2. The electronic device of claim 1,
wherein a thickness of a second fin among the plurality of second fins is thinner than a thickness of a first fin among the plurality of first fins.

3. The electronic device of claim 1,
wherein the plurality of pillars are disposed between the first cover and the second cover, and
wherein a fluid is disposed in a space between the first cover, the second cover, and the plurality of pillars.

4. The electronic device of claim 1,
wherein the vapor chamber comprises:
a first wick structure coupled to a second side of the first cover opposite to the first side of the first cover; and
a second wick structure coupled to a second side of the second cover opposite to the first side of the second cover.

5. The electronic device of claim 4,
wherein the first wick structure includes a plurality of first holes for the plurality of pillars, and
wherein the second wick structure includes a plurality of second holes for the plurality of pillars.

6. The electronic device of claim 4, further comprising:
an upper cover coupled to the second side of the first cover opposite to the first side of the first cover,
wherein the plurality of pillars are disposed between the upper cover and the second cover,
wherein the first cover is formed of a first metallic material, and
wherein the upper cover is formed of a second metallic material different from the first metallic material.

7. The electronic device of claim 6,
wherein the first metallic material comprises aluminum, and
wherein the second metallic material comprises copper.

8. The electronic device of claim 1,
wherein the first cover comprises a first clad metal formed of a first metallic material and a second metallic material, and
wherein the second cover comprises a second clad metal formed of the first metallic material and the second metallic material.

9. The electronic device of claim 8,
wherein the first metallic material comprises aluminum, and
wherein the second metallic material comprises copper.

10. The electronic device of claim 8,
wherein the first side of the first cover comprises the first metallic material of the first clad metal,
wherein the first side of the second cover comprises the first metallic material of the second clad metal,
wherein a second side of the first cover opposite to the first side comprises the second metallic material of the first clad metal, and
wherein a second side of the second cover opposite to the first side comprises the second metallic material of the second clad metal.

11. The electronic device of claim 1, further comprising:
at least one electronic component disposed on the side of the printed circuit board,
wherein the at least one electronic component is disposed to contact the housing,
wherein a temperature margin for the at least one electronic component is higher than a temperature margin for the electronic component,
wherein the electronic component includes at least one of at least one processor, a central processing unit (CPU), or a field programmable gate array (FPGA), and
wherein the at least one electronic component includes a component having a power amplifier.

12. The electronic device of claim 1, further comprising a gasket,
wherein a region of the first side of the first cover that is different from the exposed at least the portion of the first side of the first cover, is coupled to the housing through the gasket.

13. The electronic device of claim 1,
wherein the plurality of first fins are disposed on a side of the at least one heatsink portion,
wherein the plurality of first fins and the plurality of second fins protrude in a direction in which the first side of the first cover faces,
wherein each first fin of the plurality of first fins has a plate shape,
wherein each second fin of the plurality of second fins has a plate shape,
wherein the first cover of the vapor chamber includes a coating layer, and
wherein the coating layer includes the exposed at least the portion of the first side of the first cover.

14. An electronic device comprising:
a housing including a plurality of first fins;
a plurality of modules; and
a printed circuit board (PCB),
wherein each module among the plurality of modules comprises:
a plurality of second fins;
a vapor chamber including a first cover, a second cover, and a plurality of pillars; and
an electronic component,
wherein the housing includes at least one heatsink portion forming an opening region,
wherein the vapor chamber is disposed such that at least a portion of a first side of the first cover of the vapor chamber is exposed through the opening region,
wherein the plurality of second fins are disposed on the exposed at least the portion of the first side of the first cover,
wherein the electronic component is disposed on a side of the printed circuit board, and
wherein the electronic component is disposed in a space between a first side of the second cover facing the side of the printed circuit board and the side of the printed circuit board.

15. A vapor chamber comprising:
a first metal structure;
a second metal structure coupled to the first metal structure and forming a space for a fluid between the first metal structure and the second metal structure; and
a plurality of pillars disposed in the space,
wherein the first metal structure is formed based on a clad in which a first metallic material and a second metallic material are combined,
wherein the second metal structure is formed based on a clad in which the first metallic material and the second metallic material are combined,
wherein the first metal structure is disposed such that the first metallic material is located at a first side of the first metal structure and the second metallic material is located at a second side of the first metal structure opposite to the first side,
wherein the second metal structure is disposed such that the first metallic material is located at a first side of the second metal structure and the second metallic material is located at a second side of the second metal structure opposite to the first side,
wherein at least a portion of the second side of the first metal structure is coupled to at least a portion of the second side of the second metal structure,
wherein the first metallic material comprises aluminum, and
wherein the second metallic material comprises copper.
